# EUROPEAN PATENT APPLICATION

(11) **EP 2 629 006 A1**
(43) Date of publication of application: **21.08.2013**
(21) Application number: 13155463.6
(22) Date of filing: 15.02.2013
(51) Int. Cl.: F21V 33/00, A63H 3/00, A63H 3/38, H01L 33/52, H01L 33/54, F21Y 101/02

(54) **Light emitting diode and toy**

(30) Priority: 17.02.2012 US 201261600332 P; 12.10.2012 US 201261713077 P
(71) Applicant: Mattel Inc., El Segundo, California 90245-5012 (US)
(72) Inventor: Zielinski, James P., EL SEGUNDO, CA 90245 (US); Skifstriom, Eric E., EL SEGUNDO, CA 90245 (US)
(74) Representative: Cabinet Plasseraud

(57) **Abstract**

A light emitting diode (40) is provided to be used as a body part, such as an eye, for a toy. The light emitting diode includes a light emitting diode device (48) arranged in the eye. A shell (42) is disposed about the light emitting diode device and forming the exterior surface of the eye. A colored translucent portion (54) is arranged to form the iris of the eye and receive light from the light emitting device.

## Description

### CROSS-REFERNCE TO RELATED APPLICATIONS

The present Application claims the benefit of United States Provisional Application Serial No. 61/713,077 filed on 12 October 2012 and United States Provisional Application Serial No. 61/600,332 filed on 17 February 2012, the contents of which are incorporated by reference herein in their entirety.

### BACKGROUND

Various embodiments disclosed herein are related to a light emitting diode (LED), and more particularly a lens for a LED.

Light emitting diodes (LEDs) have been used as a light source in part because of their relatively small size, low power/current requirements, long life, and variety of available output wavelengths, as well as compatibility with modem circuit construction.

Accordingly, it is desirable to provide a light emitting diode with a lens or cover that expands upon existing uses.

### SUMMARY OF THE INVENTION

In one embodiment, a light emitting diode for a toy is provided. The light emitting diode includes a shell having a curved end. The curved end includes a colored translucent portion.

In another embodiment, a toy is provided. The toy includes a face having an eye. The eye includes a light emitting diode device arranged in the eye. A shell is disposed about the light emitting diode device and forming the exterior surface of the eye. The shell has a colored translucent portion.

In yet another embodiment, a toy figure is provided having at least one eye. The toy includes a light emitting diode device disposed within the at least one eye. A shell is disposed about the light emitting diode device, the shell having an end portion forming an outer surface of the eye. A colored translucent portion coupled to the end portion and disposed to receive light from the light emitting diode device.

### BRIEF DESCRIPTION OF THE DRAWINGS

These and/or other features, aspects, and advantages of the present invention will become better understood when the following detailed description is read with reference to the accompanying drawings in which like characters represent like parts throughout the drawings, wherein:

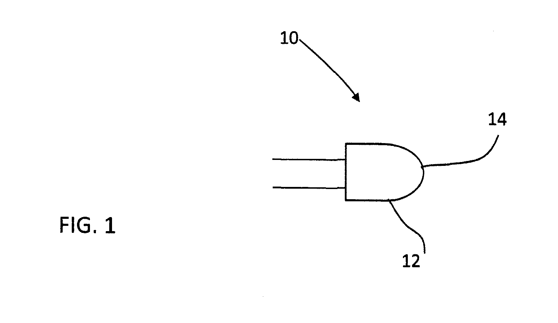

FIG. 1 is a view of an LED;

FIGs. 2A-2F illustrates various configurations of shell or lens shapes in accordance with an embodiment of the present invention;

FIG. 3 illustrates a lens cap and lighting assembly in accordance with another embodiment of the present invention;

FIG. 4A-4B illustrates exemplary images produced by the embodiment illustrated in FIG. 3;

FIG. 5 illustrates a lens cap and lighting assembly in accordance with yet another embodiment of the present invention;

FIG. 6 illustrates exemplary images produced by the embodiment illustrated in FIG. 5;

FIG. 7 illustrates a side view of an LED device in accordance with another embodiment of the invention;

FIG. 8 illustrates a top view of the LED device of FIG. 7; and

FIG. 9 illustrates a perspective view of a toy using the LED device of FIG. 7.

Although the drawings represent varied embodiments and features of the present invention, the drawings are not necessarily to scale and certain features may be exaggerated in order to illustrate and explain exemplary embodiments the present invention. The exemplification set forth herein illustrates several aspects of the invention, in one form, and such exemplification is not to be construed as limiting the scope of the invention in any manner.

### DETAILED DESCRIPTION

Referring now to the attached FIGS., a light emitting diode (LED) 10 is illustrated. As is known the related arts LED 10 is a semiconductor light source comprising a chip of semiconducting material doped with impurities to create a p-n junction. The semiconductor chip is typically potted in a shell 12. In one implementation, the shell 12 is molded out of a plastic material. The molded plastic shell 12 provides several functions one of which is to shape the light emission from the semiconductor by acting as a diffusing lens thereby allowing light to be emitted at a higher angle of incidence.

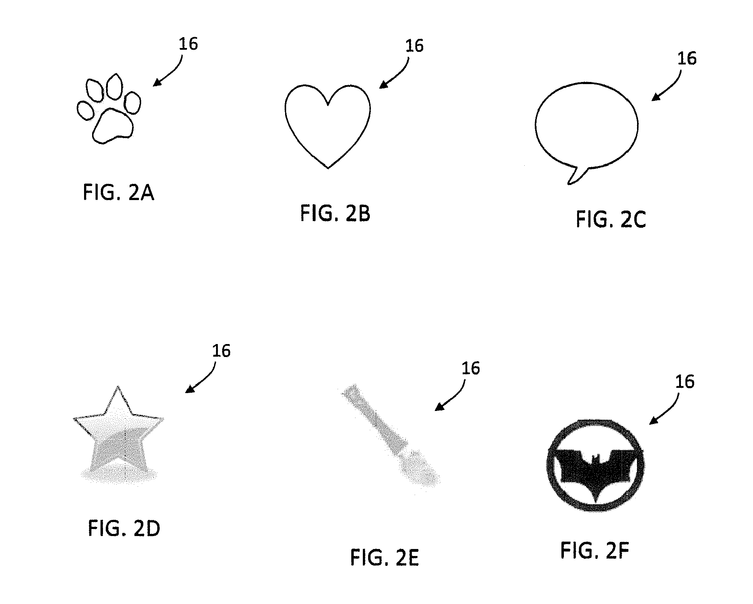

In a typical construction, an end portion 14 of the plastic shell has a curved surface. In accordance with one non-limiting embodiment of the present invention, shell 12 and end portion 14 is configured to have a unique shape 16 corresponding to a desired feature. Non-limiting examples of such shapes are illustrated in FIGs. 2A-2F for example, a paw print, a heart, a star, a paintbrush, an insignia and a test balloon. Of course, numerous other configurations and/or shapes are considered to be within the scope of exemplary embodiments of the present invention. Accordingly and when illuminated by the LED, the unique shape represented by reconfigured shell 12 is also illuminated and may be projected to a certain distance from the end of the shell 12. Furthermore, the material comprising shell 12 (e.g., plastic or any other equivalent material) can be molded with a desired color or alternatively be clear and the LED itself provides the desired color. As may be appreciated, the reconfigured shell 12 adds esthetic value to the LED at little or no cost.

In alternative embodiments, the end portion 14 includes a decal, sticker, paint, adhesive or other tacky and/or opaque layer on the end portion 14. The opaque layer includes the unique shape 16. The unique shape 16 blocks emission of light in a pattern corresponding to the unique shape 16 such that a shadow of the shape appears within the LED's area of illumination.

Referring now to FIGS. 2 - 4, another embodiment of the present invention is illustrated. Here a lens cap or sleeve 18 is provided. In this embodiment, the lens cap or sleeve 18 has a graphical image 20 disposed on either an interior surface 21 or exterior surface 23 of the lens cap 19. The lens cap or sleeve 18 is configured to be positioned over LED 10 and when the lens cap is placed over the LED 10 at a first focal length with respect to the LED 10, the graphical image 20 is projected on a surface 22. Still further and in one embodiment, the lens cap 18 is movably mounted with respect to the LED 10 such that the lens cap 20 can be moved in the directions of arrows 24 (e.g., inwardly and outwardly with respect to the LED) to change the effect and focus of the image 20 being projected. In other words and depending upon the focal point of the image 20, movement of the lens cap or sleeve 18 will change the appearance of image 20 being projected.

In yet another implementation, the lens cap 18 is provided with multiple images 20 each being provided at different locations and/or having different focal lengths with respect to the LED 10 such that as the lens cap 18 moves in the directions of arrows 24 with respect to LED 10 different images may be generated or come into and out of focus as the lens cap 18 is moved in the directions of arrows 24 with respect to LED 10.

Accordingly and through the combination of LED 10 and lens cap 18, an image projection system 26 is provided. In one embodiment, projection of the image is desired to be approximately 6 centimeters from the lens cap or sleeve 18. It should be appreciated that distances greater or less than the aforementioned 6 cm are considered to be within the scope of exemplary embodiments of the present invention.

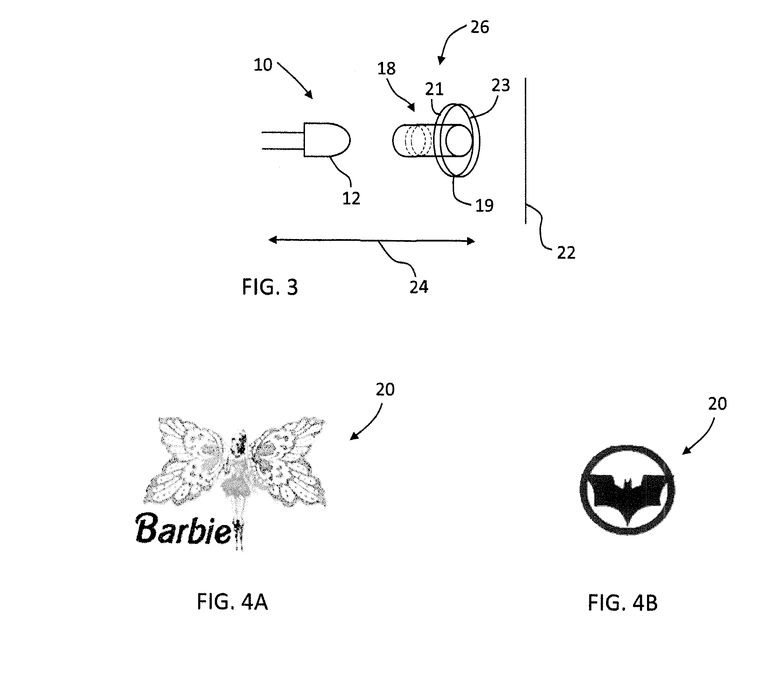

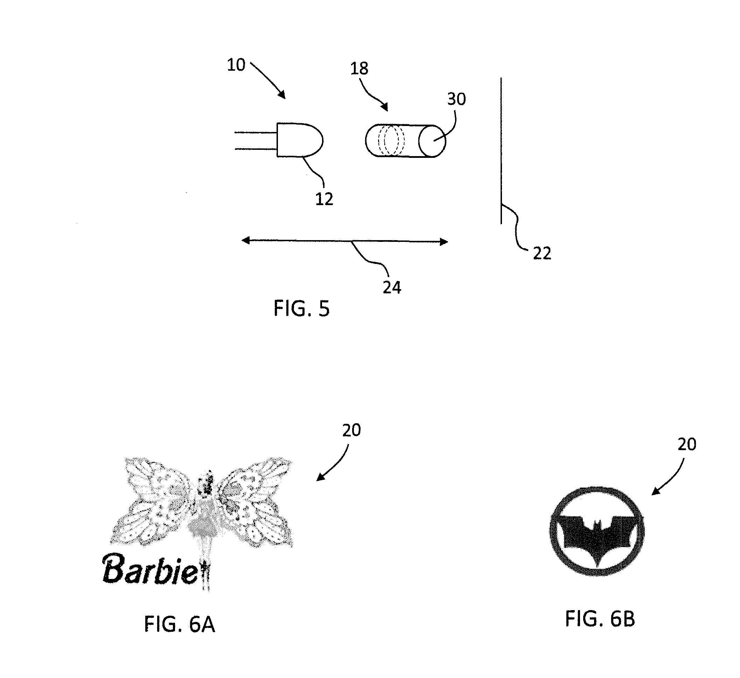

Referring now to FIGS. 5 and 6, another alternative embodiment of the present invention is illustrated. Here the lens cap or sleeve 18 is provided with a lenticular lens 30 such that depending on the location of the lens cap or sleeve 18 with respect to the LED 10 and/or the position of an observer with respect to the projection system 26 different graphical images 20 or combinations thereof are provided. Accordingly and in this embodiment, the lens cap or sleeve 18 has multiple graphical images 20 disposed on either an interior or exterior surface of the lens cap that are projected or magnified through the use of a lenticular lens 30. Similar to the embodiment of FIGS. 3 and 4, the lens cap or sleeve 18 is configured to be positioned over LED 10 and when the lens cap is placed over the LED 10, at least one of the graphical images 20 is projected on a surface or viewable upon a surface of the lens cap or sleeve 18. As previously mentioned, the lens cap or sleeve 18 is movably mounted with respect to the LED 10 such that the lens cap or sleeve 18 can be moved in the directions of arrows 24 (e.g., inwardly and outwardly with respect to the LED 10) to change the effect and focus of the image 20 and/or the image 20 being projected.

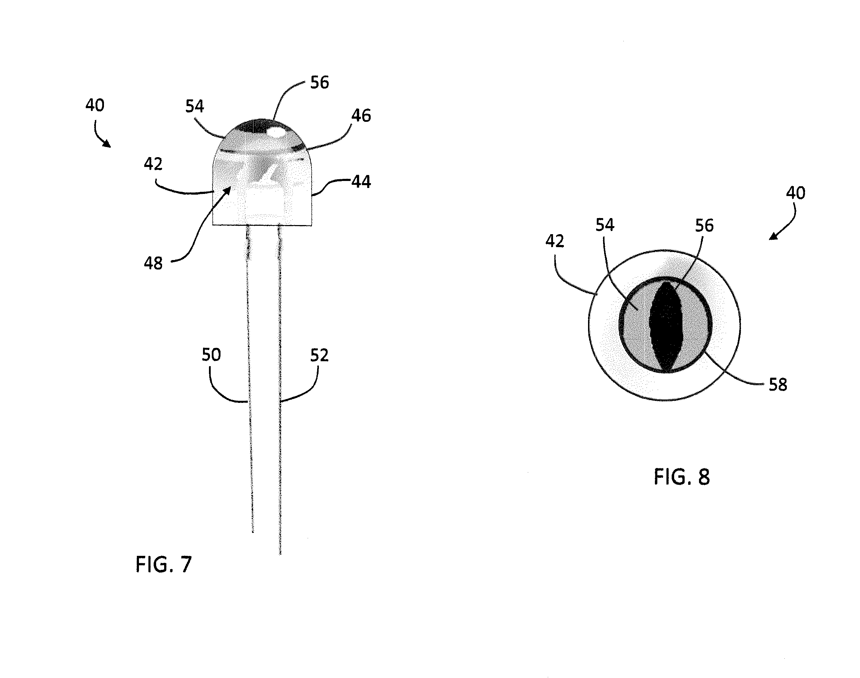

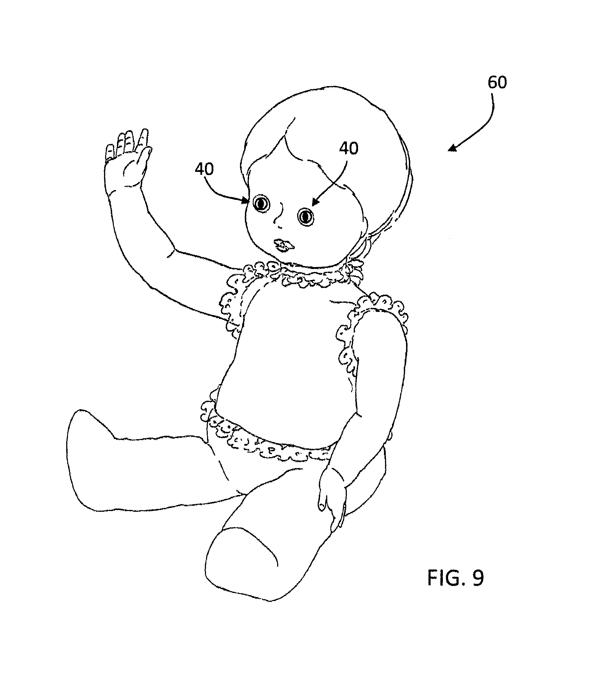

Referring now FIG.7-FIG.9, another exemplary LED 40 is shown where the LED 40 is configured in the shape and appearance of an eye for a toy, such as a cat's eye for example. In this embodiment, the LED 40 includes a shell 42 having a substantially cylindrical portion 44 and a curved end portion 46. The shell 42 is a molded member made from a suitable plastic material such as acrylic for example. In alternative embodiments, the shell 42 may be manufactured from an epoxy. Arranged within the shell 42 is an LED device 48 that generates light when current or voltage is applied to the leads 50, 52. The LED device 48 may include a semiconductor die and a lead frame comprising an anvil and a post. The semiconductor die may rest within a reflective cavity and be electrically connected to the anvil and post, which may serve as a cathode and an anode (e.g. leads 50, 52) for the LED device 48, respectively. It should be appreciated that the LED device 48 may include driver circuitry such as a ballast resistor or other electrical components as is known in the art.

The LED 40 is sized and shaped to be used in a toy figure 60, such as a doll, for example, to represent a physical feature of the toy 60 such as an eye. To simulate the look of an eye, the LED 40 includes an iris portion 54 and a pupil portion 56. In one exemplary embodiment, the iris portion 54 comprises a tinted translucent or semi translucent layer potted within the shell 42. The translucent layer may include a thin colored plastic that is curved to match the interior curvature of the curved end portion 46. The potted translucent layer passes light generated by the LED device 48 through the curved end portion 46 of the LED 40. The pupil portion 56 may be opaque such that light generated by the LED device 48, is blocked from exiting the curved end portion 46 of the LED 40 through that portion. In some embodiments, the pupil portion 56 includes a layer of dye or ink potted or embedded within the LED 40. The dye or ink may be printed, stamped, or otherwise affixed to the translucent layer that forms the iris portion 54. In some embodiments, a circular portion 58 is disposed about the iris portion 54. The circular portion 58 may be opaque or translucent. In one embodiment, the circular portion 58 is translucent and a different color than the iris portion 54. The circular portion 58 may serve to further distinguish the iris portion 54 from the remainder of the LED 40. Additional light generated by the LED device 48 may exit the LED 40 through other portions of the LED 40, such as the cylindrical portion 44 of the LED 40. The net effect of activating the exemplary LED 40 is to simulate an eye where the iris and the "white" of the eye glow. Potting or manufacturing a tinted layer within the LED 40, as opposed to on the external surface of the LED, may allow for a more realistic look to the eye. The thin epoxy layer between the tinted layer and the external surface of the LED 40 may more accurately simulate the look and reflectivity from the organic layer of moisture on a real eyeball.

In other embodiments, the iris 54 and a pupil 56 may be formed via a coating applied to the surface of the curved portion 46. The coating may be but is not limited to a paint, a gel-coat, and ink or other suitable material, for example. In one embodiment the coating may include phosphors that change the color of the light being emitted from the LED 40. In other embodiments the translucent iris portion 54 may be a colored additive material that is integrated with the plastic material during the molding process. In still other embodiments, the iris portion 54 or the pupil portion 56 may be a separately formed component that is coupled to the exterior of the shell 42, such as by adhesive bonding, for example.

The LED 40 may be used in a toy figure 60, such as on a face of the toy 60 to simulate an eye, for example. The LED 40 may be embedded within an eye socket of the toy figure 60. The curved portion 46 may form the exterior portion of the eye visible to the user. When the LED is illuminated, the light will transfer through the shell 42 and the iris portion 54, while being blocked or partially blocked by the opaque pupil portion 56. The LED 40 may be electrically coupled to electronics, such as a processor and a power source, within the head and/or torso of the toy figure 60. The LED 40 may be controlled by the processor. For example, the level of illumination from the LED 40 may be controlled to provide the appearance of a cat's eye collecting and reflecting low levels of ambient light in near-dark conditions. In other embodiments, the processor may control the LED 40 using pulse-width modulation in order to simulate a "twinkle" in the eye.

As used herein, the terms "first," "second," and the like, herein do not denote any order, quantity, or importance, but rather are used to distinguish one element from another, and the terms "a" and "an" herein do not denote a limitation of quantity, but rather denote the presence of at least one of the referenced item. In addition, it is noted that the terms "bottom" and "top" are used herein, unless otherwise noted, merely for convenience of description, and are not limited to any one position or spatial orientation.

The modifier "about" used in connection with a quantity is inclusive of the stated value and has the meaning dictated by the context (e.g., includes the degree of error associated with measurement of the particular quantity).

While the invention has been described with reference to an exemplary embodiment, it will be understood by those skilled in the art that various changes may be made and equivalents may be substituted for elements thereof without departing from the scope of the invention. In addition, many modifications may be made to adapt a particular situation or material to the teachings of the invention without departing from the essential scope thereof. Therefore, it is intended that the invention not be limited to the particular embodiment disclosed as the best mode contemplated for carrying out this invention, but that the invention will include all embodiments falling within the scope of the appended claims.

## Claims

1. A light emitting diode for a toy, comprising:
a shell having a curved end;
a colored translucent portion having a predetermined shape operably coupled to the curved end; and
a light generating portion disposed within the shell, the light generating portion configured to direct light towards the translucent portion.

2. The light emitting diode as in claim 1, wherein the shell is formed in the shape of an eye and the translucent portion is embedded within the shell and forms an iris portion of the eye.

3. The light emitting diode as in claim 2 further comprising an opaque portion on the curved end that forms a pupil portion of the eye.

4. The light emitting diode as in claim 1, further comprising a sleeve movably disposed over the shell, the translucent portion being operably coupled to the sleeve on an end opposite the light generating portion.

5. The light emitting diode as in claim 1 wherein the translucent portion is formed from a gel-coat.

6. The light emitting diode as in claim 3 wherein the translucent portion includes phosphors configured to change the color of the light passing through the translucent portion.

7. A toy comprising:
a face having an eye;
a light emitting diode device arranged in the eye;
a shell disposed about the light emitting diode device and forming the exterior surface of the eye; and
a colored translucent portion operably coupled to the shell.

8. The toy of claim 7, wherein the translucent portion is formed from a layer embedded within the shell.

9. The toy of claim 8 wherein the translucent portion includes phosphors configured to change the color of light received from the light emitting diode device.

10. The toy as in claim 9 further comprising an opaque portion centrally positioned on the translucent portion.

11. The toy of claim 10 wherein the opaque portion forms a pupil of the eye.

12. The toy of claim 7 further comprising a sleeve disposed a least partially over the shell, the translucent portion being operably coupled to the sleeve..

13. The toy of claim 12 further comprising a lens cap disposed on an end of the sleeve opposite the shell.

14. The toy of claim 13 wherein the translucent portion is disposed on a surface of the lens cap.
